# FASCICULE DE BREVET EUROPEEN

(11) **EP 4 625 095 B1**
(45) Date de publication et mention de la délivrance du brevet: **07.10.2026**
(21) Numéro de dépôt: 25165386.1
(22) Date de dépôt: 21.03.2025
(51) Int. Cl.: G06F 1/04, G06F 1/08, G06F 1/24

(54) **CIRCUIT ET PROCEDE DE GENERATION D'UN SIGNAL D'HORLOGE**
SCHALTUNG UND VERFAHREN ZUR ERZEUGUNG EINES TAKTSIGNALS
CIRCUIT AND METHOD FOR GENERATING A CLOCK SIGNAL

(30) Priorité: 29.03.2024 FR 2403229
(43) Date de publication de la demande: 01.10.2025
(73) Titulaire: STMicroelectronics International N.V., 1228 Plan-les-Ouates, Geneva (CH)
(72) Inventeur: FERRAND, Olivier, 13620 CARRY LE ROUET (FR); EVA, Christophe, 13790 ROUSSET (FR)
(74) Mandataire: Cabinet Beaumont

(56) Documents cités:
- EP-A2- 0 895 358
- US-A1- 2003 058 052
- US-A1- 2009 049 325
- US-A1- 2014 197 870
- US-A1- 2023 025 363

## Description

### Domaine technique

La présente description concerne de façon générale la génération des signaux d'horloge dans les circuits électroniques.

### Technique antérieure

Dans un circuit électronique, un signal d'horloge est un signal périodique utilisé pour rythmer les opérations du circuit. La fréquence du signal d'horloge est un paramètre important pour assurer la bonne exécution de ces opérations.

Lors de l'initialisation d'un générateur de signal d'horloge d'un circuit électronique, par exemple lors du démarrage du circuit électronique, la fréquence du signal d'horloge peut fluctuer autour d'une fréquence cible avant de se stabiliser Le document EP 0 895 358 A2 décrit un tel circuit électronique.

Des fluctuations de la fréquence du signal d'horloge au-delà de la fréquence cible peuvent provoquer des erreurs dans certains circuits électroniques. Une solution consiste à attendre que la fréquence se soit stabilisée avant d'effectuer des opérations. Cette solution cause cependant une perte de temps pendant le démarrage des circuits électroniques au cours duquel ces circuits sont en attente. Résumé de l'invention

Un mode de réalisation prévoit un dispositif électronique selon la revendication 1.

Selon un mode de réalisation, le premier circuit électronique comprend une boucle à phase asservie configurée pour générer le premier signal d'horloge et le deuxième signal.

Selon un mode de réalisation, le deuxième circuit électronique comprend un diviseur de fréquence configuré pour effectuer la division de la fréquence du premier signal.

Selon un mode de réalisation, le deuxième circuit électronique comprend un multiplexeur ayant une sortie reliée au diviseur de fréquence, une première entrée configurée pour recevoir le premier facteur et une deuxième entrée configurée pour recevoir le deuxième facteur, le multiplexeur étant configuré pour transmettre le premier facteur lorsque le deuxième signal est à la première valeur et pour transmettre le deuxième facteur lorsque le deuxième signal est à la deuxième valeur.

Selon un mode de réalisation, le deuxième circuit électronique comprend :
- un premier diviseur de fréquence ayant une entrée configurée pour recevoir le premier facteur et configuré pour effectuer la division de la fréquence du premier signal par le premier facteur ; et
- un deuxième diviseur de fréquence ayant une entrée configurée pour recevoir le deuxième facteur et configuré pour effectuer la division de la fréquence du premier signal par le deuxième facteur.

Selon un mode de réalisation, le deuxième circuit électronique comprend un multiplexeur ayant une première entrée reliée à la sortie du premier diviseur de fréquence et une deuxième entrée reliée à la sortie du deuxième diviseur de fréquence, le multiplexeur étant configuré pour transmettre le signal reçu sur la première entrée lorsque le deuxième signal est à la première valeur et pour transmettre le signal reçu sur la deuxième entrée lorsque le deuxième signal est à la deuxième valeur.

Selon un mode de réalisation, le deuxième circuit comprend un circuit de synchronisation configuré pour synchroniser le deuxième signal avec le premier signal.

Selon un mode de réalisation, le premier facteur est un nombre entier, supérieur ou égal à deux.

Un autre mode de réalisation prévoit un procédé de génération d'un signal d'horloge de sortie selon la revendication 8.

Selon un mode de réalisation, le procédé comprend en outre la synchronisation du deuxième signal avec le premier signal par un circuit de synchronisation.

Selon un mode de réalisation, le premier facteur est un nombre entier, supérieur ou égal à deux.

Selon un mode de réalisation, le procédé comprend en outre, après la génération des premier et deuxième signaux, la conversion des premier et deuxième signaux analogiques en signaux numériques.

Selon un mode de réalisation, le procédé comprend en outre la transmission, par le deuxième circuit électronique, par un multiplexeur à un diviseur de fréquence, du premier facteur lorsque le deuxième signal est à la première valeur et du deuxième facteur lorsque le deuxième signal est à la deuxième valeur.

Selon un mode de réalisation, le procédé comprend en outre la division de la fréquence du premier signal par le premier facteur par un premier diviseur de fréquence du deuxième circuit électronique et la division de la fréquence du premier signal par le deuxième facteur par un deuxième diviseur de fréquence du deuxième circuit électronique.

Selon un mode de réalisation, le procédé comprend en outre la transmission, par un multiplexeur du deuxième circuit électronique, du signal issu du premier diviseur de fréquence lorsque le deuxième signal est à la première valeur et du signal issu du deuxième diviseur de fréquence lorsque le deuxième signal est à la deuxième valeur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente, sous forme de blocs, un exemple de dispositif électronique générant un signal d'horloge, selon un mode de réalisation de la présente description ;
la figure 1B représente, sous forme de blocs, un autre exemple de dispositif électronique générant un signal d'horloge, selon un autre mode de réalisation de la présente description ;
la figure 1C représente schématiquement et sous forme de blocs un exemple de boucle à phase asservie d'un circuit des figures 1A et 1B;
la figure 2 représente graphiquement un exemple d'évolution de la fréquence du signal d'horloge généré par le dispositif de la figure 1A ou de la figure 1B ; et
la figure 3 est un chronogramme représentant un exemple de signaux présents dans le dispositif de la figure 1B; et
la figure 4 représente, sous forme d'organigramme, un procédé de génération du signal d'horloge des figures 1A à 3 selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des techniques pour estimer quand un signal d'horloge est devenu stable en fréquence sont connues par l'homme du métier et ne sont pas détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

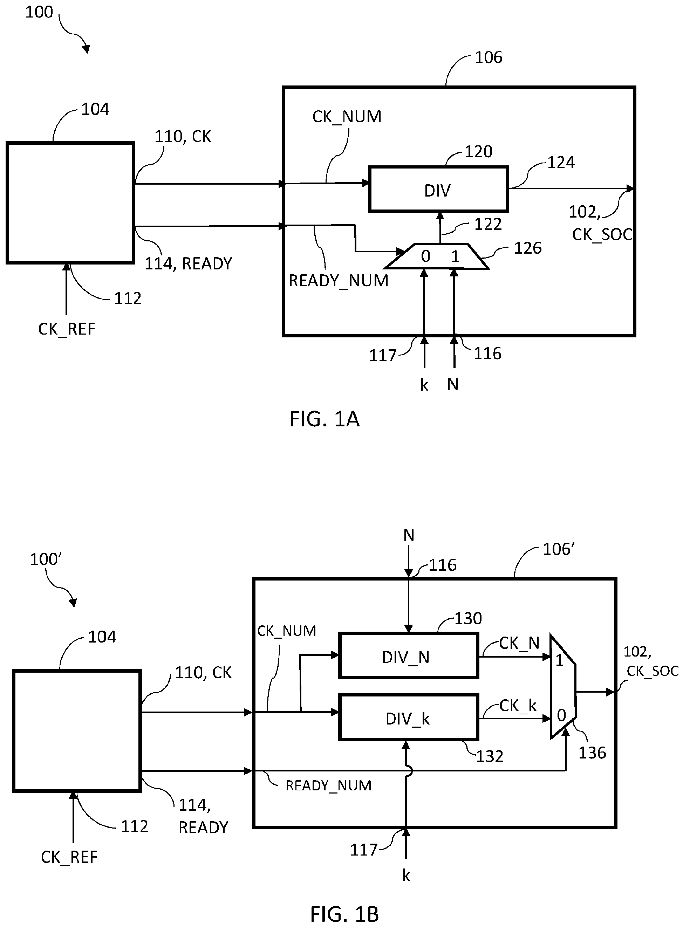

La figure 1A représente, sous forme de blocs, un exemple de dispositif électronique 100 générant un signal d'horloge de sortie CK_SOC à une sortie 102, selon un mode de réalisation de la présente description.

Le dispositif électronique 100 comprend un premier circuit 104, par exemple un circuit analogique, et un deuxième circuit 106, par exemple un circuit numérique. Le deuxième circuit 106 est configuré pour générer le signal d'horloge de sortie CK_SOC, qui est par exemple fourni à un système sur puce (en anglais, « System on a Chip », SoC, non représenté dans la figure 1A), comprenant par exemple un ensemble de circuits numériques cadencés par le signal d'horloge de sortie CK_SOC.

Le premier circuit 104 comprend des sorties 110 et 114, et est configuré pour transmettre à la sortie 110 un signal d'horloge CK et à la sortie 114 un signal READY indiquant l'état de stabilité du signal CK.

Le premier circuit 104 comprend par exemple une entrée 112 configurée pour recevoir un paramètre physique de référence, par exemple une tension, un courant, une température, une fréquence, etc. Dans l'exemple de la figure 1A, le paramètre physique de référence est un signal d'horloge CK_REF ayant une fréquence de référence. Le premier circuit 104 est par exemple configuré pour générer le signal d'horloge CK à partir du paramètre physique de référence, par exemple par l'intermédiaire d'une boucle à phase asservie.

Au cours d'un intervalle de temps, par exemple suivant le démarrage du circuit 104, le signal d'horloge CK est généré avec une fréquence variant au cours du temps avant de se stabiliser autour d'une fréquence cible FQ_TARGET qui est fonction du paramètre physique de référence. La fréquence cible FQ_TARGET est par exemple un paramètre fixé lors de la conception du circuit 104. Le signal READY est par exemple initialisé à une première valeur, par exemple à une première valeur de tension, au démarrage du premier circuit 104. Le signal READY est configuré pour prendre une deuxième valeur, par exemple une deuxième valeur de tension, lorsque la fréquence du signal CK est devenue stable autour de FQ_TARGET. La génération du signal READY est par exemple obtenue par un comparateur de fréquence configuré pour comparer la fréquence du signal CK à la fréquence FQ_TARGET. Par exemple, le signal READY indique quand l'amplitude des fluctuations en fréquence du signal CK est inférieure à x% de la fréquence FQ_TARGET, où x est par exemple compris dans la plage 1 à 10%, et de préférence égal à environ 5%.

Selon un autre mode de réalisation, le circuit 104 est configuré pour générer le signal READY avec la première valeur pendant un premier intervalle de temps fixe à partir du démarrage du premier circuit 104 et avec la deuxième valeur à la fin du premier intervalle de temps.

Le deuxième circuit 106 comprend des entrées reliées à la sortie 110 et à la sortie 114 du circuit 104 et est configuré pour prendre en entrée le signal d'horloge CK fourni par la sortie 110 et le signal READY fourni par la sortie 114. Le deuxième circuit 106 comprend également des entrées 116 et 117, et est configuré pour recevoir à l'entrée 116 un facteur de division N et à l'entrée 117 un paramètre k. Le facteur de division N et le paramètre k sont par exemple fournis par un système de gestion, tel qu'un processeur hôte (non représenté) . Le circuit 106 est configuré pour générer le signal d'horloge CK_SOC. Le paramètre k est par exemple un entier, supérieur ou égal à deux, correspondant à un facteur de division minimal à appliquer à la fréquence du signal d'horloge CK pour obtenir un signal d'horloge avec une fréquence plus faible, inférieure à FQ_TARGET, lorsque le signal READY est à la première valeur, par exemple suite au démarrage du premier circuit 104. Le facteur de division N est par exemple un nombre entier inférieur ou égal à k pouvant varier au cours de l'utilisation du dispositif 100. Le facteur de division N correspond au facteur à appliquer à la fréquence du signal d'horloge CK pour obtenir un signal d'horloge avec une fréquence plus faible, par exemple adapté au fonctionnement du système sur puce cadencé par le signal d'horloge CK_SOC.

Le signal READY généré par le circuit 104 est par exemple asynchrone avec le signal CK. Le circuit 106 comprend par exemple un circuit de synchronisation, non illustré dans la figure 1A, pour synchroniser le signal READY sur le signal CK et ainsi obtenir un signal numérique synchronisé READY_NUM. Dans certains cas, le circuit de synchronisation transforme également le signal d'horloge CK en un signal d'horloge numérique CK_NUM. Par exemple, le circuit de synchronisation est configuré pour convertir le niveau de tension présent sur la sortie 110 du circuit 104 en un niveau de tension conforme pour des circuits numériques qui vont recevoir le signal d'horloge CK_NUM. Des circuits de synchronisation sont connus de l'homme du métier et la réalisation du circuit de synchronisation ne sera pas décrite en détail.

Selon un mode de réalisation, le circuit 106 comprend un diviseur de fréquence 120 (« DIV ») prenant en entrée le signal CK_NUM et un signal de commande 122 et étant configuré pour générer à une sortie 124 le signal d'horloge de sortie CK_SOC.

Le circuit 106 comprend par exemple un circuit de commande 126, par exemple un multiplexeur. Le circuit de commande 126 prend par exemple en entrée le paramètre k et le facteur de division N et est commandé par le signal READY_NUM reçu à une entrée de sélection. Le circuit de commande 126 est par exemple configuré pour générer le signal de commande 122. Le signal de commande 122 correspond par exemple au paramètre k ou au facteur de division N selon la valeur du signal de sélection READY_NUM.

Selon un mode de réalisation, il est souhaité que le signal d'horloge de sortie CK_SOC soit généré à une fréquence égale à la fréquence FQ_TARGET divisée par N. Lorsque le signal READY_NUM est à la première valeur, la fréquence est divisée par le paramètre k pour réduire le risque d'un dépassement de la fréquence FQ_TARGET. Le circuit de commande 126 est alors configuré pour que le signal de commande 122 indique un facteur de division égal au paramètre k. Le diviseur de fréquence 120 est alors configuré pour générer le signal CK_SOC avec une fréquence égale à la fréquence du signal CK_NUM divisée par k. Lorsque le signal READY_NUM est à la deuxième valeur, le circuit de commande 126 est alors configuré pour que le signal de commande 122 indique un facteur de division égal au paramètre N. Le diviseur de fréquence 120 est alors configuré pour générer le signal CK_SOC avec une fréquence égale à la fréquence du signal CK_NUM divisée par N.

Selon un autre mode de réalisation, le facteur de division N prend également des valeurs supérieures à k. La fréquence du signal CK_NUM est alors par exemple divisée par N pour toute valeur du signal READY.

Selon un mode de réalisation, la valeur de N est égale à 1, et le diviseur 120 n'effectue pas de division mais propage le signal CK_NUM directement vers la sortie 102. Dans ce cas, le circuit 106 pourrait comprend également un deuxième circuit de commande, par exemple un multiplexeur, non illustré en figure 1A, configuré pour recevoir le signal de sortie du diviseur de fréquence 120 et le signal CK_NUM et configuré pour transmettre le signal CK_NUM à la sortie 102 si N est égal à 1 et que le signal READY_NUM est à la deuxième valeur et pour transmettre le signal de sortie du diviseur de fréquence 120 sinon. Ce mode de réalisation permet d'économiser des ressources lorsqu'une division de la fréquence du signal CK_NUM est inutile.

Le dispositif 100 fait par exemple partie d'un dispositif électronique, par exemple un téléphone mobile, un ordinateur, une tablette électronique, etc.

La figure 1B représente, sous forme de blocs, un autre exemple de dispositif électronique 100' générant le signal d'horloge CK_SOC, selon un autre mode de réalisation de la présente description.

Certains éléments de la figure 1B sont similaires à des éléments de la figure 1A. Ils sont référencés avec les mêmes références et ne seront pas décrits à nouveau en détails.

Un circuit 106' du dispositif 100' comprend des entrées reliées à la sortie 110 du circuit 104 et à la sortie 114 du circuit 104 et est configuré pour prendre en entrée le signal d'horloge CK fourni par la sortie 110 et le signal READY fourni par la sortie 114. Le circuit 106' comprend également les entrées 116 et 117, et est configuré pour recevoir à l'entrée 116 le facteur de division N et à l'entrée 117 le paramètre k. Le circuit 106' est configuré pour générer le signal d'horloge CK_SOC. Par rapport au circuit 106 de la figure 1A, le circuit 106' comprend, à la place du diviseur 120, deux diviseurs de fréquence DIV_N 130 et DIV_k 132. Le diviseur de fréquence DIV_N est configuré pour recevoir le signal CK_NUM et le facteur de division N et pour transmettre un signal CK_N correspondant au signal CK_NUM avec une fréquence divisée par N. Le diviseur de fréquence DIV_k est configuré pour recevoir le signal CK_NUM et le paramètre k et pour transmettre un signal CK_k correspondant au signal CK_NUM avec une fréquence divisée par k. Le circuit 106' comprend également un circuit de sélection 136, par exemple un multiplexeur, configuré pour recevoir les signaux CK_N et CK_k en entrée et le signal READY_NUM en signal de commande et configuré pour générer le signal CK_SOC correspondant au signal CK_k lorsque le signal READY_NUM est à la première valeur et correspondant au signal CK_N lorsque le signal READY_NUM est à la deuxième valeur.

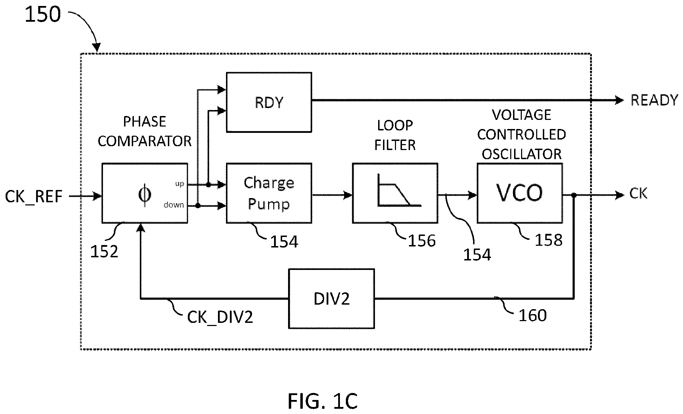

La figure 1C représente schématiquement et sous forme de blocs un exemple de boucle à phase asservie 150. Ce circuit fait par exemple partie du circuit 104 de la figure 1A ou de la figure 1B, et est configuré pour générer le signal READY et le signal d'horloge CK sur la base du signal d'horloge CK_REF.

La boucle à phase asservie 150 comprend par exemple un comparateur de phase 152 (Φ, « PHASE COMPARATOR »), une pompe de charge 154 (« Charge Pump »), un filtre de boucle 156 (« LOOP FILTER ») et un oscillateur contrôlé en tension 158 (VCO, « VOLTAGE CONTROLLED OSCILLATOR »).

L'oscillateur contrôlé en tension 158 est configuré pour générer le signal d'horloge CK qui est également fourni à un diviseur de fréquence DIV2 de la boucle à phase asservie 150 par le biais d'une boucle d'asservissement 160. Le diviseur de fréquence DIV2 est configuré pour générer un signal CK_DIV2 correspondant au signal CK ayant une fréquence divisée par un entier, cet entier étant égal à FQ_TARGET divisée par la fréquence du signal CK_REF. Le signal CK_DIV2 généré par le diviseur de fréquence DIV2 est transmis au comparateur de phase 152.

Le comparateur de phase 152 prend également en entrée le signal CK_REF et est configuré pour comparer la fréquence du signal CK_DIV2 à la fréquence du signal CK_REF. Le comparateur de phase 152 est par exemple configuré pour générer un ou plusieurs signaux représentatifs de la différence entre les fréquences des signaux CK_DIV2 et CK_REF et pour les fournir à la pompe de charge 154 et à un circuit de traitement RDY. Dans l'exemple de la figure 1C, le comparateur de phase 152 est configuré pour générer un premier signal up indiquant que la fréquence du signal CK_DIV2 est inférieure à la fréquence du signal CK_REF, et la tension fournie au VCO 158 augmente. Le comparateur de phases 152 est également configuré pour générer un deuxième signal down indiquant que la fréquence du signal CK_DIV2 est supérieure à la fréquence du signal CK_REF, et la tension fournie au VCO 158 diminue.

La pompe de charge 154 est par exemple configurée pour générer une tension dont le niveau dépend de la comparaison des signaux CK_REF et CK_DIV2. Par exemple, la tension en sortie de la pompe de charge 154 augmente si la fréquence du signal CK_DIV2 est inférieure à la fréquence du signal CK_REF.

Le filtre de boucle 156 est par exemple configuré pour filtrer le signal de sortie de la pompe de charge et pour le transmettre au VCO 158. Le VCO 158 est configuré pour générer le signal CK ayant une fréquence dépendant de la tension reçue à son entrée. Par exemple, si la fréquence de CK_DIV2 est inférieure à la fréquence de CK_REF et que la tension en sortie de la pompe de charge 154 augmente, la tension transmise par le filtre de boucle 156 au VCO augmente également et la fréquence du signal CK généré par le VCO 158 augmente à son tour. Lorsque le signal CK est stable, sa fréquence est égale à FQ_TARGET et le signal CK_DIV2 a une fréquence égale à CK_REF.

La fréquence du signal CK_REF est par exemple inférieure à la fréquence FQ_TARGET. Le VCO 158 génère le signal CK avec une fréquence plus élevée que celle de CK_REF. La présence du diviseur de fréquence DIV2 permet une comparaison du signal CK au signal CK_REF, par l'intermédiaire de la génération du signal CK_DIV2.

Le circuit de traitement RDY est configuré pour générer le signal READY en fonction du ou des signaux résultant de la comparaison des signaux CK_REF et CK_DIV2. Par exemple, le signal READY prend la deuxième valeur lorsque la boucle à phase asservie est verrouillée, c'est-à-dire lorsque la fréquence du signal CK_DIV2 est par exemple différente d'un maximum de x% de la fréquence du signal CK_REF, par exemple sur plusieurs boucles d'asservissement successives, où x est par exemple dans la plage de 1 à 10%, et de préférence égal à environ 5%.

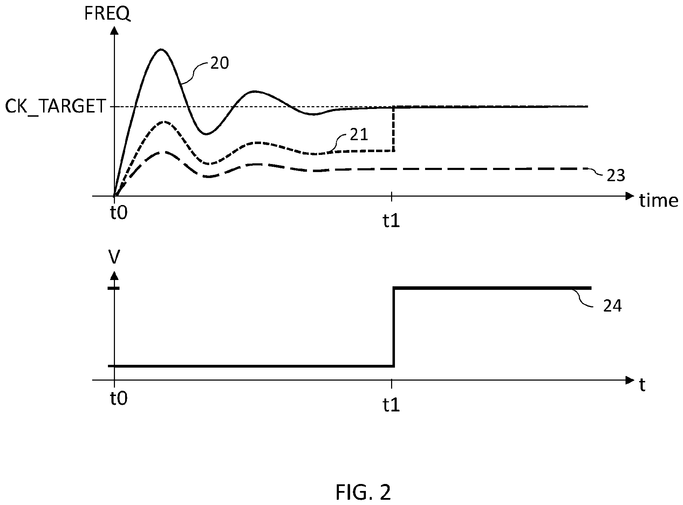

La figure 2 représente graphiquement un exemple d'évolution de la fréquence (« FREQ ») 20 du signal d'horloge CK au cours du temps (« t »), l'évolution de la fréquence 21 du signal d'horloge de sortie CK_SOC correspondante si le facteur de division N est égal à 1, l'évolution de la fréquence 23 du signal d'horloge de sortie CK_SOC correspondante si le facteur de division N est égal à 3, et de la tension (« V ») 24 du signal READY_NUM générés par le dispositif 100 de la figure 1A ou par le dispositif 100' de la figure 1B.

Selon un mode de réalisation, le signal CK est généré par le circuit 104 à partir de l'instant t0, par exemple lorsque le circuit 104 est allumé. Au cours d'une période s'étalant de t0 à t1, la fréquence 20 du signal CK varie significativement au cours du temps et prend par exemple des valeurs supérieures à la fréquence FQ_TARGET, et la tension 24 du signal READY_NUM est à la première valeur, par exemple une faible tension.

A l'instant t1, la fréquence 20 du signal CK a atteint la fréquence FQ_TARGET et est stable. A l'instant t1, la tension 24 du signal READY_NUM passe de la première valeur à la deuxième valeur, par exemple le signal READY_NUM passe d'une tension faible à une tension élevée. Après l'instant t1, le signal READY_NUM reste à la deuxième valeur.

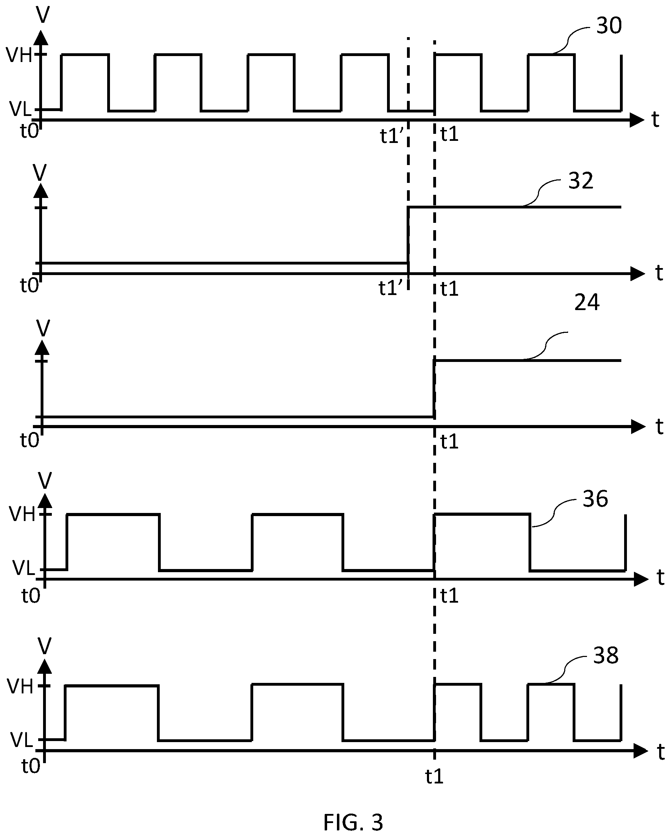

Si le facteur de division N est égal à 1, entre l'instant t0 et l'instant t1, la fréquence 21 du signal CK_SOC est égale à la fréquence 20 du signal CK divisée par le paramètre k, par 2 dans l'exemple de la figure 3. La fréquence 21 du signal CK_SOC est égale à la fréquence 20 du signal CK à partir de l'instant t1. Le paramètre k est choisi de sorte que la fréquence 21 du signal CK_SOC ne dépasse pas la fréquence FQ_TARGET.

Si le facteur de division N est supérieur à k, par exemple 3, la fréquence 21 du signal CK_SOC est par exemple égale à la fréquence 20 du signal CK divisée par le facteur de division N. Malgré les variations de fréquence présentes entre l'instant t0 et l'instant t1, la fréquence 23 n'excède par exemple pas la fréquence FQ_TARGET.

La figure 3 est un chronogramme représentant un exemple de signaux présents dans le dispositif de la figure 1B. Sont représentés l'évolution de la tension (« V ») 30 du signal d'horloge numérique CK_NUM et de la tension 32 du signal READY émis par le circuit 104 au cours du temps (« t »), l'évolution de la tension 24 du signal READY_NUM, l'évolution de la tension 36 du signal CK_k et l'évolution de la tension 38 du signal CK_SOC.

Le signal CK_NUM est un signal oscillant entre deux valeurs, par exemple une tension basse (« VL ») et une tension haute (« VH »), au cours du temps. Sa fréquence varie par exemple entre l'instant t0 de la figure 2, correspondant par exemple au démarrage du circuit 104, et un instant t1', correspondant à l'instant où le signal CK est considéré comme stable par le circuit 104, et correspondant donc au moment de bascule du signal READY entre la première valeur et la deuxième valeur. Dans l'exemple de la figure 3, la tension 30 du signal CK_NUM est un signal créneau comprenant des fronts montants, instants où le signal passe de la tension basse à la tension haute, et des fronts descendants, instants où le signal passe de la tension haute à la tension basse. Un instant t1 correspond par exemple au front du signal CK_NUM suivant l'instant t1'. Selon le mode de réalisation illustré dans la figure 3, l'instant t1 correspond au front montant du signal CK_NUM suivant l'instant t1'. Selon un autre mode de réalisation, non illustré, l'instant t1 correspond au front descendant du signal CK_NUM suivant l'instant t1'.

Selon un mode de réalisation, le signal CK est généré par le circuit 104 à partir de l'instant t0. Au cours d'une période s'étalant de l'instant t0 à l'instant t1', la fréquence du signal CK varie par exemple au cours du temps et prend par exemple des valeurs supérieures à la fréquence cible telle que définie par la fréquence FQ_TARGET, et la tension 32 du signal READY est à la première valeur, par exemple une faible tension.

A l'instant t1', la fréquence du signal CK a atteint la valeur cible FQ_TARGET et est stable. A l'instant t1', la tension 32 du signal READY passe de la première valeur à la deuxième valeur, par exemple le signal READY passe d'une tension faible à une tension élevée. Après l'instant t1', le signal READY reste à la deuxième valeur. L'instant t1 étant après l'instant t1', le signal READY est à la deuxième valeur de tension.

Le signal READY_NUM prend une troisième valeur de tension entre les instants t0 et t1 et une quatrième valeur de tension après l'instant t1. La troisième valeur de tension est par exemple inférieure à la quatrième valeur de tension. Selon un mode de réalisation, la troisième valeur de tension est égale à la première valeur de tension et la quatrième valeur de tension est inférieure à la deuxième valeur de tension. La transition de la troisième valeur de tension vers la quatrième valeur de tension est effectuée à l'instant t1, défini ci-dessus.

Dans l'exemple de la figure 3, le paramètre k est égal à 2 et le signal CK_SOC est obtenu pour un facteur de division N égal à 1. La fréquence du signal CK_k correspond à la fréquence du signal CK_NUM divisée par le paramètre k, soit 2. Dans l'exemple de la figure 3, le signal CK_k est un signal en créneaux oscillant entre les valeurs VL et VH.

Entre les instants t0 et t1, le signal CK_SOC correspond au signal CK_k et à partir de l'instant t1, le signal CK_SOC correspond au signal CK_N, non illustré dans la figure 3, égal au signal CK_NUM dans le cas où N est égal à un.

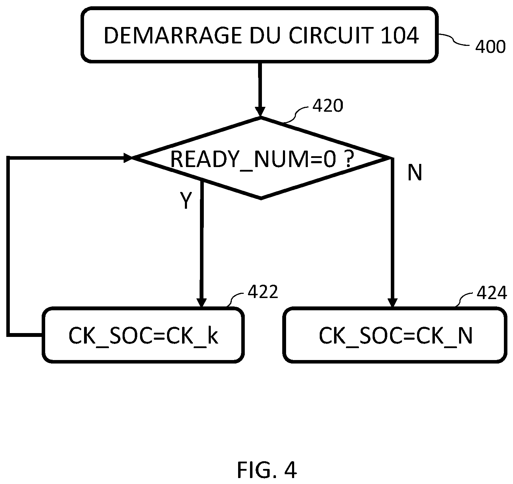

La figure 4 représente, sous forme d'organigramme, un procédé de génération du signal d'horloge CK_SOC des figures 1A à 3 selon un mode de réalisation.

Dans une étape 400 (« DEMARRAGE DU CIRCUIT 104 »), le circuit 104 est allumé. Les signaux CK et READY sont générés par le circuit 104 et par exemple synchronisés par le circuit 106.

Dans une étape 420 (« READY_SYNC=0 ? ») suivant l'étape 400, le signal READY_NUM est lu par le circuit de commande 126 de la figure 1A ou par le circuit de commande 136 de la figure 1B et la valeur du signal READY_NUM est par exemple comparée à la première valeur.

Si, à l'étape 420, le signal READY_NUM est à la première valeur (sortie « Y » du bloc 420), alors, dans une étape 422 (« CK_SOC=CK_k »), le circuit de commande 126 est configuré pour transmettre le paramètre k au diviseur de fréquence 120 ou le circuit de sélection 136 est configuré pour transmettre le signal d'horloge de sortie CK_SOC correspondant au signal CK_k. Après l'étape 422, le procédé retourne à l'étape 420, qui est répétée jusqu'à ce que le signal READY_NUM prenne la deuxième valeur.

Si, à l'étape 420, le signal READY_NUM est à la deuxième valeur (sortie « N » du bloc 420), alors, dans une étape 424 (« CK_SOC=CK_N »), le circuit de commande 126 est configuré pour transmettre le facteur de division N au diviseur de fréquence 120 ou le circuit de sélection 136 est configuré pour transmettre le signal d'horloge de sortie CK_SOC correspondant au signal CK_N.

Un avantage de diviser la fréquence du signal CK_NUM par k entre les instants t0 et t1, si le facteur de division N est inférieur au paramètre k, est que le système sur puce cadencé par le signal d'horloge CK_SOC puisse utiliser le signal CK_SOC dès l'instant t0 en réduisant le risque que la fréquence du signal CK_SOC ne soit trop élevée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que soit prévu le cas de pouvoir varier le facteur de division N, dans d'autres cas, il est toujours souhaité d'utiliser un signal avec la fréquence du signal CK non divisée et le facteur de division N n'est pas fourni au dispositif 100.

Enfin, la mise en oeuvre pratique des modes de réalisation et variantes décrits est à la portée de la personne du métier à partir des indications fonctionnelles données ci-dessus. Par exemple, des diviseurs de fréquence sont bien connus dans l'art et leur mise en oeuvre pratique est donc à la portée de l'homme du métier.

## Revendications

1. Dispositif électronique (100), comprenant :
- un premier circuit électronique (104) configuré pour générer un premier signal d'horloge (CK) et un deuxième signal (READY) indiquant un état de stabilité de la fréquence du premier signal, le deuxième signal ayant une première valeur au cours d'une première période à partir du démarrage du premier circuit électronique (104) et une deuxième valeur après la première période ; et
- un deuxième circuit électronique (106) configuré pour générer un signal d'horloge de sortie (CK_SOC) ayant une fréquence égale à la fréquence du premier signal (CK) divisée par un premier facteur (k) lorsque le deuxième signal (READY) est à la première valeur et ayant la fréquence du premier signal (CK), ou une fréquence égale à la fréquence du premier signal (CK) divisée par un deuxième facteur (N) inférieur au premier facteur, à partir de l'instant du front du premier signal d'horloge (CK) suivant un changement du deuxième signal (READY) vers la deuxième valeur.

2. Dispositif électronique selon la revendication 1, dans lequel le premier circuit électronique (104) comprend une boucle à phase asservie configurée pour générer le premier signal d'horloge (CK) et le deuxième signal (READY).

3. Dispositif électronique selon l'une quelconque des revendications 1 à 2, dans lequel le deuxième circuit électronique (106) comprend un diviseur de fréquence (120, 130, 132) configuré pour effectuer la division de la fréquence du premier signal (CK), le deuxième circuit électronique (106) comprenant par exemple un multiplexeur (126) ayant une sortie reliée au diviseur de fréquence (120), une première entrée configurée pour recevoir le premier facteur (k) et une deuxième entrée configurée pour recevoir le deuxième facteur (N), le multiplexeur (126) étant par exemple configuré pour transmettre le premier facteur lorsque le deuxième signal (READY) est à la première valeur et pour transmettre le deuxième facteur lorsque le deuxième signal (READY) est à la deuxième valeur.

4. Dispositif électronique selon l'une quelconque des revendications 1 à 2, dans lequel le deuxième circuit électronique (106) comprend :
- un premier diviseur de fréquence (132) ayant une entrée configurée pour recevoir le premier facteur (k) et configuré pour effectuer la division de la fréquence du premier signal (CK) par le premier facteur ; et
- un deuxième diviseur de fréquence (130) ayant une entrée configurée pour recevoir le deuxième facteur (N) et configuré pour effectuer la division de la fréquence du premier signal (CK) par le deuxième facteur.

5. Dispositif électronique selon la revendication 4, dans lequel le deuxième circuit électronique (106) comprend un multiplexeur (136) ayant une première entrée reliée à la sortie du premier diviseur de fréquence (132) et une deuxième entrée reliée à la sortie du deuxième diviseur de fréquence (130), le multiplexeur (136) étant configuré pour transmettre le signal reçu sur la première entrée lorsque le deuxième signal (READY) est à la première valeur et pour transmettre le signal reçu sur la deuxième entrée lorsque le deuxième signal (READY) est à la deuxième valeur.

6. Dispositif électronique selon l'une quelconque des revendications 1 à 5, dans lequel le deuxième circuit (106) comprend un circuit de synchronisation configuré pour synchroniser le deuxième signal (READY) avec le premier signal (CK).

7. Dispositif électronique selon l'une quelconque des revendications 1 à 6, dans lequel le premier facteur (k) est un nombre entier, supérieur ou égal à deux.

8. Procédé de génération d'un signal d'horloge de sortie (CK_SOC), comprenant :
- la génération par un premier circuit électronique (104) d'un premier signal d'horloge (CK) et d'un deuxième signal (READY) indiquant un état de stabilité de la fréquence du premier signal, le deuxième signal ayant une première valeur au cours d'une première période à partir du démarrage du premier circuit électronique (104) et une deuxième valeur après la première période ; et
- la génération, par un deuxième circuit électronique (106), du signal d'horloge de sortie (CK_SOC) ayant une fréquence égale à la fréquence du premier signal (CK) divisée par un premier facteur (k) lorsque le deuxième signal (READY) est à la première valeur et ayant la fréquence du premier signal (CK), ou une fréquence égale à la fréquence du premier signal (CK) divisée par un deuxième facteur (N) inférieur au premier facteur, à partir de l'instant du front du premier signal d'horloge (CK) suivant un changement du deuxième signal (READY) vers la deuxième valeur.

9. Procédé selon la revendication 8, comprenant en outre la synchronisation du deuxième signal (READY) avec le premier signal (CK) par un circuit de synchronisation.

10. Procédé selon l'une quelconque des revendications 8 à 9, dans lequel le premier facteur (k) est un nombre entier, supérieur ou égal à deux.

11. Procédé selon l'une quelconque des revendications 8 à 10, comprenant en outre, après la génération des premier (CK) et deuxième (READY) signaux, la conversion des premier (CK) et deuxième (READY) signaux analogiques en signaux numériques (CK_NUM, READY_NUM).

12. Procédé selon l'une quelconque des revendications 8 à 11, comprenant en outre la transmission, par le deuxième circuit électronique (106), par un multiplexeur (126) à un diviseur de fréquence (120), du premier facteur (k) lorsque le deuxième signal (READY) est à la première valeur et du deuxième facteur (N) lorsque le deuxième signal (READY) est à la deuxième valeur.

13. Procédé selon l'une quelconque des revendications 8 à 12, comprenant en outre la division de la fréquence du premier signal (CK) par le premier facteur (k) par un premier diviseur de fréquence (132) du deuxième circuit électronique (106) et la division de la fréquence du premier signal (CK) par le deuxième facteur (N) par un deuxième diviseur de fréquence (130) du deuxième circuit électronique (106), et comprenant par exemple en outre la transmission, par un multiplexeur (136) du deuxième circuit électronique (106), du signal issu du premier diviseur de fréquence (132) lorsque le deuxième signal (READY) est à la première valeur et du signal issu du deuxième diviseur de fréquence (130) lorsque le deuxième signal (READY) est à la deuxième valeur.

## Patentansprüche

1. Eine elektronische Einrichtung (100), die Folgendes aufweist:
- eine erste elektronische Schaltung (104), die eingerichtet ist zum Erzeugen eines ersten Taktsignals (CK) und eines zweiten Signals (READY), das einen Stabilitätszustand der Frequenz des ersten Signals angibt, wobei das zweite Signal während einer ersten Periode ab dem Starten der ersten elektronischen Schaltung (104) einen ersten Wert und nach der ersten Periode einen zweiten Wert aufweist; und
- eine zweite elektronische Schaltung (106), die eingerichtet zum Erzeugen eines Ausgangs-Taktsignals (CK_SOC) ist, das eine Frequenz aufweist, die gleich der Frequenz des ersten Signals (CK) geteilt durch einen ersten Faktor (k) ist, wenn das zweite Signal (READY) den ersten Wert aufweist, und das die Frequenz des ersten Signals (CK) oder eine Frequenz aufweist, die gleich der Frequenz des ersten Signals (CK) geteilt durch einen zweiten Faktor (N), der kleiner als der erste Faktor ist, ab dem Zeitpunkt der Flanke des ersten Taktsignals (CK), die auf eine Änderung des zweiten Signals (READY) zu dem zweiten Wert folgt.

2. Die elektronische Einrichtung nach Anspruch 1, wobei die erste elektronische Schaltung (104) eine Phasenregelschleife aufweist, die eingerichtet zum Erzeugen des ersten Taktsignals (CK) und des zweiten Signals (READY) ist.

3. Die elektronische Einrichtung nach einem der Ansprüche 1 bis 2, wobei die zweite elektronische Schaltung (106) einen Frequenzteiler (120, 130, 132) aufweist, der eingerichtet zum Durchführen der Teilung der Frequenz des ersten Signals (CK) ist, wobei die zweite elektronische Schaltung (106) beispielsweise einen Multiplexer (126) aufweist, der einen Ausgang aufweist, der mit dem Frequenzteiler (120) gekoppelt ist, einen ersten Eingang aufweist, der eingerichtet zum Empfangen des ersten Faktors (k) ist, und einen zweiten Eingang aufweist, der eingerichtet zum Empfangen des zweiten Faktors (N) ist, wobei der Multiplexer (126) eingerichtet zum Übertragen des ersten Faktors ist, wenn das zweite Signal (READY) den ersten Wert aufweist, und eingerichtet zum Übertragen des zweiten Faktors ist, wenn das zweite Signal (READY) den zweiten Wert aufweist.

4. Die elektronische Einrichtung nach einem der Ansprüche 1 bis 2, wobei die zweite elektronische Schaltung (106) Folgendes aufweist:
- einen ersten Frequenzteiler (132), der einen Eingang aufweist, der eingerichtet zum Empfangen des ersten Faktors (k) ist, und eingerichtet zum Durchführen der Teilung der Frequenz des ersten Signals (CK) durch den ersten Faktor ist; und
- einen zweiten Frequenzteiler (130), der einen Eingang aufweist, der eingerichtet zum Empfangen des zweiten Faktors (N) ist, und eingerichtet zum Durchführen der Teilung der Frequenz des ersten Signals (CK) durch den zweiten Faktor ist.

5. Die elektronische Einrichtung nach Anspruch 4, wobei die zweite elektronische Schaltung (106) einen Multiplexer (136) aufweist, der einen ersten Eingang hat, der mit dem Ausgang des ersten Frequenzteilers (132) gekoppelt ist, und einen zweiten Eingang hat, der mit dem Ausgang des zweiten Frequenzteilers (130) gekoppelt ist, wobei der Multiplexer (136) eingerichtet zum Übertragen des an dem ersten Eingang empfangenen Signals ist, wenn das zweite Signal (READY) den ersten Wert aufweist, und eingerichtet zum Übertragen des an dem zweiten Eingang empfangenen Signals ist, wenn das zweite Signal (READY) den zweiten Wert aufweist.

6. Die elektronische Einrichtung nach einem der Ansprüche 1 bis 5, wobei die zweite Schaltung (106) eine Synchronisationsschaltung aufweist, die eingerichtet zum Synchronisieren des zweiten Signals (READY) mit dem ersten Signal (CK) ist.

7. Die elektronische Einrichtung nach einem der Ansprüche 1 bis 6, wobei der erste Faktor (k) eine ganze Zahl ist, die größer oder gleich zwei ist.

8. Ein Verfahren zum Erzeugen eines Ausgangs-Taktsignals (CK_SOC), das Folgendes aufweist:
- das Erzeugen durch eine erste elektronische Schaltung (104) eines ersten Taktsignals (CK) und eines zweiten Signals (READY), das einen Stabilitätszustand der Frequenz des ersten Signals angibt, wobei das zweite Signal während einer ersten Periode ab dem Starten der ersten elektronischen Schaltung (104) einen ersten Wert aufweist und nach der ersten Periode einen zweiten Wert aufweist; und
- das Erzeugen durch eine zweite elektronische Schaltung (106) des Ausgangs-Taktsignals (CK_SOC), das eine Frequenz aufweist, die gleich der Frequenz des ersten Signals (CK) geteilt durch einen ersten Faktor (k) ist, wenn das zweite Signal (READY) den ersten Wert aufweist, und die Frequenz des ersten Signals (CK) oder eine Frequenz aufweist, die gleich der Frequenz des ersten Signals (CK) geteilt durch einen zweiten Faktor (N), der kleiner als der erste Faktor ist, ab dem Zeitpunkt der Flanke des ersten Taktsignals (CK), die auf eine Änderung des zweiten Signals (READY) zu dem zweiten Wert folgt.

9. Das Verfahren nach Anspruch 8, ferner aufweisend das Synchronisieren des zweiten Signals (READY) mit dem ersten Signal (CK) durch eine Synchronisationsschaltung.

10. Das Verfahren nach einem der Ansprüche 8 bis 9, wobei der erste Faktor (k) eine ganze Zahl ist, die größer oder gleich zwei ist.

11. Das Verfahren nach einem der Ansprüche 8 bis 10, ferner aufweisend nach dem Erzeugen des ersten Signals (CK) und des zweiten Signals (READY) das Umwandeln des ersten analogen Signals (CK) und des zweiten analogen Signals (READY) in digitale Signale (CK_NUM, READY_NUM).

12. Das Verfahren nach einem der Ansprüche 8 bis 11, ferner aufweisend das Übertragen durch die zweite elektronische Schaltung (106) über einen Multiplexer (126) an einen Frequenzteiler (120) des ersten Faktors (k), wenn das zweite Signal (READY) den ersten Wert aufweist, und des zweiten Faktors (N), wenn das zweite Signal (READY) den zweiten Wert aufweist.

13. Das Verfahren nach einem der Ansprüche 8 bis 12, ferner aufweisend das Teilen der Frequenz des ersten Signals (CK) durch den ersten Faktor (k) durch einen ersten Frequenzteiler (132) der zweiten elektronischen Schaltung (106) und das Teilen der Frequenz des ersten Signals (CK) durch den zweiten Faktor (N) durch einen zweiten Frequenzteiler (130) der zweiten elektronischen Schaltung (106), und beispielsweise ferner aufweisend das Übertragen durch einen Multiplexer (136) der zweiten elektronischen Schaltung (106) des von dem ersten Frequenzteiler (132) stammenden Signals, wenn das zweite Signal (READY) den ersten Wert aufweist, und des von dem zweiten Frequenzteiler (130) stammenden Signals, wenn das zweite Signal (READY) den zweiten Wert aufweist.

## Claims

1. Electronic device (100), comprising :
- a first electronic circuit (104) configured to generate a first clock signal (CK) and a second signal (READY) indicating a state of stability of the frequency of the first signal, the second signal having a first value during a first period from the starting of the first electronic circuit (104) and a second value after the first period; and
- a second electronic circuit (106) configured to generate an output clock signal (CK_SOC) having a frequency equal to the frequency of the first signal (CK) divided by a first factor (k) when the second signal (READY) is at the first value and having the frequency of the first signal (CK), or a frequency equal to the frequency of the first signal (CK) divided by a second factor (N) smaller than the first factor, from the instant of the edge of the first clock signal (CK) following a change of the second signal (READY) to the second value.

2. Electronic device according to claim 1, wherein the first electronic circuit (104) comprises a phase-locked loop configured to generate the first clock signal (CK) and the second signal (READY).

3. Electronic device according to any of claims 1 to 2, wherein the second electronic circuit (106) comprises a frequency divider (120, 130, 132) configured to perform the division of the frequency of the first signal (CK), the second electronic circuit (106) for example comprising a multiplexer (126) having an output coupled to the frequency divider (120), a first input configured to receive the first factor (k) and a second input configured to receive the second factor (N), the multiplexer (126) being configured to transmit the first factor when the second signal (READY) is at the first value and to transmit the second factor when the second signal (READY) is at the second value.

4. Electronic device according to any of claims 1 to 2, wherein the second electronic circuit (106) comprises:
- a first frequency divider (132) having an input configured to receive the first factor (k) and configured to perform the division of the frequency of the first signal (CK) by the first factor; and
- a second frequency divider (130) having an input configured to receive the second factor (N) and configured to perform the division of the frequency of the first signal (CK) by the second factor.

5. Electronic device according to claim 4, wherein the second electronic circuit (106) comprises a multiplexer (136) having a first input coupled to the output of the first frequency divider (132) and a second input coupled to the output of the second frequency divider (130), the multiplexer (136) being configured to transmit the signal received on the first input when the second signal (READY) is at the first value and to transmit the signal received on the second input when the second signal (READY) is at the second value.

6. Electronic device according to any of claims 1 to 5, wherein the second circuit (106) comprises a synchronization circuit configured to synchronize the second signal (READY) with the first signal (CK).

7. Electronic device according to any of claims 1 to 6, wherein the first factor (k) is an integer greater than or equal to two.

8. Method of generating an output clock signal (CK_SOC), comprising:
- the generation by a first electronic circuit (104) of a first clock signal (CK) and of a second signal (READY) indicating a state of stability of the frequency of the first signal, the second signal having a first value during a first period from the starting of the first electronic circuit (104) and a second value after the first period; and
- the generation, by a second electronic circuit (106), of the output clock signal (CK_SOC) having a frequency equal to the frequency of the first signal (CK) divided by a first factor (k) when the second signal (READY) is at the first value and having the frequency of the first signal (CK), or a frequency equal to the frequency of the first signal (CK) divided by a second factor (N) smaller than the first factor, from the instant of the edge of the first clock signal (CK) following a change of the second signal (READY) to the second value.

9. Method according to claim 8, further comprising the synchronization of the second signal (READY) with the first signal (CK) by a synchronization circuit.

10. Method according to any of claims 8 to 9, wherein the first factor (k) is an integer greater than or equal to two.

11. Method according to any of claims 8 to 10, further comprising, after the generation of the first (CK) and second (READY) signals, the conversion of the first (CK) and second (READY) analog signals into digital signals (CK_NUM, READY_NUM).

12. Method according to any of claims 8 to 11, further comprising the transmission, by the second electronic circuit (106), via a multiplexer (126) to a frequency divider (120), of the first factor (k) when the second signal (READY) is at the first value and of the second factor (N) when the second signal (READY) is at the second value.

13. Method according to any of claims 8 to 12, further comprising the division of the frequency of the first signal (CK) by the first factor (k) by a first frequency divider (132) of the second electronic circuit (106) and the division of the frequency of the first signal (CK) by the second factor (N) by a second frequency divider (130) of the second electronic circuit (106), and for example comprising the transmission, by a multiplexer (136) of the second electronic circuit (106), of the signal originating from the first frequency divider (132) when the second signal (READY) is at the first value and of the signal originating from the second frequency divider (130) when the second signal (READY) is at the second value.
